(19) Europäisches Patentamt
European Patent Office
Office européen des brevets

(11) **EP 2 917 746 B1**

(12) **EUROPÄISCHE PATENTSCHRIFT**

(45) Veröffentlichungstag und Bekanntmachung des Hinweises auf die Patenterteilung:
**24.02.2021 Patentblatt 2021/08**

(21) Anmeldenummer: **13789281.6**

(22) Anmeldetag: **08.11.2013**

(51) Int Cl.:
*G01R 29/20* *(2006.01)*     *H02H 7/045* *(2006.01)*

(86) Internationale Anmeldenummer:
**PCT/EP2013/073325**

(87) Internationale Veröffentlichungsnummer:
**WO 2014/072444 (15.05.2014 Gazette 2014/20)**

(54) **VERFAHREN UND VORRICHTUNG ZUR ÜBERWACHUNG EINES ZUSTANDS EINES TRANSFORMATORS**

METHOD AND APPARATUS FOR MONITORING THE CONDITION OF A TRANSFORMER

PROCÉDÉ ET APPAREIL DE SURVEILLANCE D'UNE CONDITION D'UN TRANSFORMATEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.11.2012 DE 102012220474**

(43) Veröffentlichungstag der Anmeldung:
**16.09.2015 Patentblatt 2015/38**

(73) Patentinhaber: **Bombardier Transportation GmbH**
**10785 Berlin (DE)**

(72) Erfinder:
• **PENDHARKAR, Ishan**
**CH-8051 Zürich (CH)**
• **VRTEK, Juraj**
**CH-8606 Greifensee (CH)**
• **STIEGELER, Roland**
**79725 Laufenburg (DE)**
• **FAVEZ, Jean-Yves**
**CH-8603 Schwerzenbach (CH)**

(74) Vertreter: **Ramrath, Lukas**
**Patentanwälte Bressel und Partner mbB**
**Potsdamer Platz 10**
**10785 Berlin (DE)**

(56) Entgegenhaltungen:
**US-A1- 2003 036 821**

• **P. BASTARD ET AL: "A transformer model for winding fault studies", IEEE TRANSACTIONS ON POWER DELIVERY, Bd. 9, Nr. 2, 1. April 1994 (1994-04-01), Seiten 690-699, XP055102963, ISSN: 0885-8977, DOI: 10.1109/61.296246**
• **KANG ET AL: "Transformer protection relay based on the induced voltages", INTERNATIONAL JOURNAL OF ELECTRICAL POWER & ENERGY SYSTEMS, JORDAN HILL, OXFORD, GB, Bd. 29, Nr. 4, 13. Januar 2007 (2007-01-13), Seiten 281-289, XP005829678, ISSN: 0142-0615, DOI: 10.1016/J.IJEPES.2006.08.001**
• **KANG Y-C ET AL: "Protection, faulted phase and winding identification for the three-winding transformer using the increments of flux linkages", IET GENERATION, TRANSMISSION & DISTRIBUTION,, Bd. 4, Nr. 9, 6. September 2010 (2010-09-06), Seiten 1060-1068, XP006036238, ISSN: 1751-8695, DOI: 10.1049/IET-GTD:20100094**
• **MLADEN KEZUNOVIC ET AL: "Modeling and Simulation of the Power Transformer Faults and Related Protective Relay Behavior", IEEE TRANSACTIONS ON POWER DELIVERY, IEEE SERVICE CENTER, NEW YORK, NY, US, Bd. 15, Nr. 1, 1. Januar 2000 (2000-01-01) , Seiten 44-50, XP011049768, ISSN: 0885-8977, DOI: 10.1109/61.847227**
• **DARWISH H A ET AL: "Step-by-Step Simulation of Transformer Winding Faults for Electromagnetic Transient Programs", PES TD 2005/2006 MAY 21-24, 2006, PISCATAWAY, NJ, USA,IEEE, PISCATAWAY, NJ, USA, 21. Mai 2006 (2006-05-21), Seiten 177-182, XP031331037, ISBN: 978-0-7803-9194-9**

- GOUDA OSAMA E ET AL: "Turn-to-earth fault modelling of power transformer based on symmetrical components", IET GENERATION, TRANSMISSION&DISTRIBUTION, IET, UK, Bd. 7, Nr. 7, 1. Juli 2013 (2013-07-01), Seiten 709-716, XP006045639, ISSN: 1751-8687, DOI: 10.1049/IET-GTD.2012.0724

- PATEL A ET AL: "Multi-secondary transformer: A modeling technique for simulation", FUSION ENGINEERING (SOFE), 2011 IEEE/NPSS 24TH SYMPOSIUM ON, IEEE, 26 June 2011 (2011-06-26), pages 1-5, XP032061987, DOI: 10.1109/SOFE.2011.6052231 ISBN: 978-1-4577-0669-1

**Beschreibung**

Die Erfindung betrifft ein Verfahren und eine Vorrichtung zur Überwachung eines Zustands einer Windung eines Transformators, insbesondere zur Überwachung mindestens eines Windungszahlverhältnisses des Transformators.

Ein Transformator ist eines der teuersten elektrischen Bauteile, der in zahlreichen elektrischen Anwendungen benötigt wird. So werden Leistungstransformatoren z.B. bei der Erzeugung und Verteilung von elektrischer Leistung genutzt.

Es ist wünschenswert, einen Zustand des Transformators auch während eines Betriebs des Transformators zu überwachen. So können z.B. Parameter des Transformators überwacht werden, um eine Fehlfunktion oder einen drohenden Ausfall frühzeitig zu erkennen und somit ein Risiko des Ausfalls zu minimieren.

Die EP 2 474 832 A2 offenbart ein Verfahren zur Überwachung eines Transformatorzustandes, umfassend das Berechnen eines effektiven Windungszahlverhältnisses basierend auf einem primären elektrischen Parameter, der mit einer Primärwindung des Transformators assoziiert ist, und einem sekundären elektrischen Parameter, der mit einer Sekundärwicklung des Transformators assoziiert ist, weiter umfassend das Berechnen eines betriebsbedingten Magnetisierungsstromes basierend auf dem effektiven Windungszahlverhältnis und einem primären und sekundären Strom des Transformators oder einer primären und einer sekundären Spannung des Transformators und Bestimmung eines Windungs-Gesundheits-Indikators zumindest teilweise basierend auf dem betriebsbedingten Magnetisierungsstrom. Das in der Druckschrift beschriebene Verfahren erfordert eine Bestimmung eines so genannten Windungszahlverhältnis-Modellbildners, der für eine bestimmte Anzahl bekannter Lasten durch Experimente und/oder Simulationen bestimmt werden muss. Derartige Experimente und/oder Simulationen müssen hierbei für jeden neuen Transformator durchgeführt werden, was zeitaufwändig und teuer ist. Weiterhin beruht das in der Druckschrift beschriebene Verfahren auf der Verwendung von sinusförmigen Signalen, wodurch die Anwendbarkeit des Verfahrens eingeschränkt wird. Zudem ist das in der Druckschrift beschriebene Verfahren auf Transformatoren mit einer Primärwicklung und einer Sekundärwicklung begrenzt. Das offenbarte Verfahren erfordert jedoch einen eingeschwungenen Zustand und benötigt vorzugsweise mehrere Perioden eines harmonischen Signals für ein zuverlässiges Ergebnis.

Die Druckschrift "P. Bastard et. al., "A Transformer Model For Winding Fault Studies", IEEE Trans. On Power Delivery, vol. 9, No. 2, April 1994, Seiten 690-698" offenbart ein Verfahren zur Modellierung interner Fehler in einem Leistungstransformator.

Die Druckschrift "Y.C. Kang et. al., "Transformer Protection Relay Based on the Induced Voltages", International Journal of Electrical Power and Energy Systems, Jordan Hill, Oxford, Bd. 29, Nr. 4, Seiten 281-298, 13.01. 2007" offenbart ein Transformator-Schutzrelais, welches auf induzierten Spannungen in den Primär- und Sekundärwicklungen beruht.

Die Druckschrift "Patel A. et. al., "Multi-secondary transformer: A modeling technique for simulation", Fusion Engineering (SOFE), 2011 IEEE/NPSS 24th Symposium on, IEEE, 26. Juni 2011 (2011-06-26), Seiten 1 bis 5" diskutiert die Schwierigkeiten bei der Modellierung von Multi-Sekundär-Transformatoren.

Es stellt sich das technische Problem, ein Verfahren und eine Vorrichtung zur Überwachung eines Transformators, insbesondere zur Überwachung mindestens eines Windungszahlverhältnisses des Transformators, zu schaffen, welche eine zuverlässige, schnelle, einfache und uneingeschränkte Überwachung einer Funktionsfähigkeit des Transformators ermöglichen.

Die Lösung des technischen Problems ergibt sich durch die Gegenstände mit den Merkmalen der Ansprüche 1 und 12. Weitere vorteilhafte Ausgestaltungen der Erfindung ergeben sich aus den Unteransprüchen.

Vorgeschlagen wird ein Verfahren zur Überwachung eines Zustandes mindestens einer Windung eines Transformators. Insbesondere wird ein Verfahren zur Überwachung mindestens eines Windungszahlverhältnisses des Transformators vorgeschlagen. Dies erlaubt die Überwachung einer Funktionsfähigkeit des Transformators. Der Transformator umfasst hierbei eine Primärwicklung und mehrere Sekundärwicklungen umfassen. Auch kann der Transformator einen magnetischen Kern umfassen, um welchen herum die Primärwicklung und/oder die Sekundärwicklung(en) angeordnet sind.

Es ist eine Grundidee der Erfindung, Parameter eines dynamischen Strom-Spannungs-Modells des Transformators zu bestimmen, wobei die Überwachung des Zustandes des Transformators in Abhängigkeit dieser modellbasierten Parameter durchgeführt wird. Beispielsweise kann modellbasiert eine magnetische Kopplung zumindest zwischen eine zu überwachenden Windung und mindestens einer weiteren Windung des Transformators bestimmt werden, wobei Überwachung des Zustandes des Transformators in Abhängigkeit dieser modellbasiert bestimmten magnetischen Kopplung durchgeführt wird.

In dem vorgeschlagenen Verfahren werden ein realer Windungsstrom mindestens einer zu überwachenden Windung und eine reale Windungsstromänderung der mindestens einen zu überwachenden Windungen bestimmt. Der Windungsstrom beschreibt hierbei einen durch die zu überwachende Windung fließenden Strom während des Betriebs des Transformators. Weiter wird eine reale Windungsspannung der mindestens einen zur überwachenden Windung bestimmt. Eine Windungsspannung bezeichnet hierbei eine im Betrieb über Anschlüssen der Windung abfallende Spannung.

Real bedeutet hierbei, dass die bestimmte Größe sich tatsächlich physikalisch in/an der zu überwachenden Windung einstellt. Die Bestimmung des/der realen Windungsstroms, realen Windungsstromänderung und realen Windungsspannung umfasst hierbei das direkte Erfassen oder Messen dieser Größen, z.B. mittels Strom- oder Spannungssensoren. Auch umfasst die Bestimmung die indirekte Berechnung des/der realen Windungsstroms, realen Windungsstromänderung und realen Windungsspannung z.B. in Abhängigkeit von direkt erfassten, z.B. gemessenen, Größen, die von der jeweils berechneten Größe verschieden sind. Beim indirekten Berechnen wird die zu bestimmende Größe in Abhängigkeit von mindestens einer von der zu bestimmenden Größe verschiedenen Größe berechnet oder geschätzt. So kann z.B. die Windungsstromänderung in Abhängigkeit eines zeitlichen Verlaufs des gemessenen Windungsstroms bestimmt werden, z. B. durch Differenzierung.

Insbesondere kann der reale Windungsstrom ein gemessener Windungsstrom, die reale Windungsstromänderung eine gemessene Windungsstromänderung und die reale Windungsspannung eine gemessene Windungsspannung sein.

Weiter wird mindestens ein zu überwachender Parameter des Transformators bestimmt. Der überwachende Parameter kann hierbei ein windungsspezifischer Parameter der zu überwachenden Windung sein.

Erfindungsgemäß wird/werden als zu überwachende(r) Parameter mindestens ein von einem Windungswiderstand der mindestens einen zu überwachenden Windung abhängiger Parameter und mindestens ein von einer Selbstinduktivität und einer Gegeninduktivität der mindestens einen zu überwachenden Windung abhängiger Parameter bestimmt. Die zu überwachenden Parameter werden in Abhängigkeit eines dynamischen Strom-Spannungsmodells des Transformators bestimmt.

Mittels des dynamischen Strom-Spannungsmodells des Transformators kann beispielsweise eine geschätzte Windungsspannung der mindestens einen zu überwachenden Windung in Abhängigkeit des/der zu überwachenden Parameter(s) sowie in Abhängigkeit des realen Windungsstromes und der realen Windungsstromänderung und der realen Windungsspannung bestimmt werden (siehe Formel 1). Der/die zu überwachende(n) Parameter kann beispielsweise ein Koeffizient des realen Windungsstromes oder der realen Windungsstromänderung oder der realen Windungsspannung sein oder eine Teilgröße zur Berechnung eines solchen Koeffizienten bilden. Insbesondere ist ein zu überwachender Parameter ein Koeffizient der realen Windungsstromänderung oder eine Teilgröße des Koeffizienten der realen Windungsstromänderung.

Das dynamische Strom-Spannungsmodell kann hierbei die Ausbildung des Transformators berücksichtigen, insbesondere die Anzahl der vorhandenen Windungen. Es kann notwendig sein, dass zur Bestimmung des/der zu überwachenden Parameter(s) zusätzlich noch mindestens eine weitere reale Größen, z.B. eine reale Windungsspannung einer weiteren Windung, ein realer Windungsstrom einer weiteren Windung und/oder eine reale Windungsstromänderung einer weiteren Windung, bestimmt werden muss.

Die Überwachung wird in Abhängigkeit des/der zu überwachenden Parameter(s) durchgeführt, beispielsweise in Abhängigkeit eines zeitlichen Verlaufs des/der zu überwachenden Parameter(s).

Der Windungswiderstand der mindestens einen zu überwachenden Windung kann der vom Windungswiderstand der mindestens einen zu überwachenden Windung abhängige Parameter sein. In diesem Fall ist also der zu überwachende Parameter der Windungswiderstand.

Alternativ kann der Windungswiderstand der mindestens einen zu überwachenden Windung eine Teilgröße des zu überwachenden Parameters bilden. In diesem Fall kann noch mindestens eine weitere Teilgröße oder eine Teilinformation, die insbesondere vom Windungswiderstand der zu überwachenden Windung verschieden sein kann, notwendig sein, um den zu überwachenden Parameter zu bestimmen.

Entsprechend kann die Selbstinduktivität oder die Gegeninduktivität der mindestens einen zu überwachenden Windung der von der Selbstinduktivität und/oder der Gegeninduktivität der mindestens einen zu überwachenden Windung abhängige Parameter sein. In diesem Fall ist also der zu überwachende Parameter die Selbstinduktivität oder die Gegeninduktivität.

Alternativ kann die Selbstinduktivität oder die Gegeninduktivität der mindestens einen zu überwachenden Windung eine Teilgröße des zu überwachenden Parameters bilden. In diesem Fall kann noch mindestens eine weitere Teilgröße oder eine Teilinformation, die insbesondere von der Selbstinduktivität bzw. der Gegeninduktivität der zu überwachenden Windung verschieden sein kann, notwendig sein, um den zu überwachenden Parameter zu bestimmen. Vorzugsweise bilden sowohl die Selbstinduktivität als auch die Gegeninduktivität Teilgrößen des zu überwachenden Parameters, wobei in Abhängigkeit dieser Teilgrößen und gegebenenfalls weiterer Teilgrößen oder Teilinformationen der zu überwachende Parameter bestimmt werden kann.

Die Gegeninduktivität der mindestens einen zu überwachenden Windung bezeichnet eine aus einer Gegeninduktion zwischen der mindestens einen zu überwachenden Windung und einer weiteren Windung des Transformators resultierende Induktivität. Somit kann die Gegeninduktivität auch als magnetischer Kopplungskoeffizient zwischen der mindestens einen zu überwachenden Windung und der weiteren Windung des Transformators bezeichnet werden oder es kann dieser magnetische Kopplungskoeffizient von der Gegeninduktivität abhängen. In diesem Fall wird also unter dem Begriff magnetischer Kopplungskoeffizient ein von einer Gegeninduktivität abhängiger Koeffizient verstanden.

Im Sinne der Erfindung kann aber unter dem Begriff magnetischer Kopplungskoeffizient auch ein sowohl von einer Gegeninduktivität als auch von einer Selbstinduktivität der mindestens einen zu überwachenden Windung abhängiger Koeffizient verstanden werden.

Somit ist durch diese vorgeschlagene Ausführungsform auch ein Verfahren zur Überwachung eines Zustands eines Transformators beschrieben, wobei ein realer Windungsstrom mindestens einer zu überwachenden Windung, eine reale Windungsstromänderung der mindestens einen zu überwachenden Windung und eine reale Windungsspannung der mindestens einen zu überwachenden Windung und mindestens ein zu überwachender Parameter des Transformators bestimmt werden.

Weiter wird als zu überwachender Parameter mindestens ein magnetischer Kopplungskoeffizient in Abhängigkeit eines dynamischen Strom-Spannungsmodells des Transformators bestimmt, der eine magnetische Kopplung zwischen der zu überwachenden Windung und mindestens einer weiteren Windung des Transformators beschreibt. Hierbei kann es erforderlich sein, dass zusätzlich ein realer Windungsstrom oder eine reale Windungsstromänderung der mindestens einen weiteren Windung, die über den magnetischen Kopplungskoeffizienten mit der zu überwachenden Windung gekoppelt ist, bestimmt werden muss. Dieser Windungsstrom bzw. die Windungsstromänderung kann wiederum direkt erfasst oder indirekt berechnet werden.

Weiter wird die vorgeschlagene Überwachung in Abhängigkeit des mindestens einen magnetischen Kopplungskoeffizienten durchgeführt, beispielsweise in Abhängigkeit eines zeitlichen Verlaufs des Kopplungskoeffizienten.

Das vorgeschlagene Verfahren basiert somit unmittelbar auf physikalischen Eigenschaften des Transformators, die in dem dynamischen Strom-Spannungsmodell abgebildet werden. Da ein dynamisches Strom-Spannungsmodell des Transformators verwendet wird, kann das Verfahren in jedem beliebigen Betriebszustand des Transformators durchgeführt werden, insbesondere bei beliebigen zeitlichen Strom-/Spannungsverläufen. Insbesondere ist die Durchführung des Verfahrens nicht nur in eingeschwungenen Betriebszuständen des Transformators möglich. Insbesondere ist es nicht notwendig, dass sinusförmige Ströme und/oder Spannungen für Überwachung einzustellen sind. Durch das dynamische Strom-Spannungsmodell können z.B. beliebige zeitliche Strom- und/oder Spannungsverläufe im Transformator bestimmt oder modelliert werden. Durch das dynamische Strom-Spannungsmodell können insbesondere stationäre Strom- und/oder Spannungsverläufe, also Strom- und/oder Spannungsverläufe im eingeschwungenen Zustand, als auch instationäre Strom- und/oder Spannungsverläufe, also Strom- und/oder Spannungsverläufe im nicht eingeschwungenen Zustand, bestimmt oder modelliert werden.

Die Erfindung beruht auf der Idee, dass eine Änderung des Zustandes des Transformators, insbesondere des Windungszahlverhältnisses des Transformators, eine Änderung der Parameter im dynamischen Strom-Spannungsmodell bedingt und in Abhängigkeit der Parameter die Überwachung durchgeführt werden kann. Insbesondere kann eine Änderung des Zustandes des Transformators, insbesondere des Windungszahlverhältnisses des Transformators, auch eine Änderung einer magnetischen Kopplung zwischen zwei Windungen bedingen. Da der magnetische Kopplungskoeffizient diese magnetische Kopplung beschreibt oder abbildet, kann in Abhängigkeit des magnetischen Kopplungskoeffizienten die Überwachung durchgeführt werden.

Hierdurch ergibt sich in vorteilhafter Weise eine einfache Überwachung eines Zustands des Transformators, die in jedem Betriebszustand, insbesondere für beliebige zeitliche Verläufe von Windungsströmen und Windungsspannungen einsetzbar ist. Weiter vorteilhaft ergibt sich, dass das vorgeschlagene Verfahren als z. B. Software-Funktion in einer Auswerteeinrichtung, z. B. einem Prozessor, implementiert werden kann. Somit kann das Verfahren in einfacher Weise in eine durch die Auswerteeinrichtung gesteuerte Schaltungsanordnung, die z. B. den Transformator und daran angeschlossene Gleichrichter umfasst, integriert werden. Das vorgeschlagene Verfahren benötigt in vorteilhafter Weise auch keine zusätzlichen Sensoren als diejenigen, die typischerweise verfügbar sind. Somit werden durch die Anwendung keine zusätzlichen Kosten erzeugt. Weiter ergibt sich in vorteilhafter Weise, dass das Verfahren zeitlich schnell durchgeführt werden kann, wodurch eine frühzeitige Erkennung einer Änderung und somit auch eines eventuell risikobehafteten Zustands des Transformators möglich wird. Das in der eingangs erwähnten EP 2 474 832 A2 offenbarte Verfahren benötigt jedoch mehrere Perioden eines Signals in einem eingeschwungenen Zustand bevor Ergebnisse verfügbar sind.

In einer weiteren Ausführungsform wird/werden als zu überwachende(r) Parameter ein effektiver Widerstand und/oder eine effektive Induktivität der mindestens einen zu überwachenden Windung bestimmt.

Hierbei bezeichnet ein effektiver Widerstand einen Widerstand eines elektrischen Netzwerks zwischen Anschlüssen der mindestens einen zu überwachenden Windung. Das elektrische Netzwerk umfasst hierbei neben der mindestens einen zu überwachenden Windung auch mindestens eine weitere Windung, vorzugsweise alle weiteren Windungen, des Transformators, die hin zur Seite der zu überwachenden Windung transformiert sein kann/können. Der effektive Widerstand dieses elektrischen Netzwerks zwischen den Anschlüssen ist hierbei zusätzlich zu dem Windungswiderstand der zu überwachenden Windung auch von einem Windungswiderstand mindestens einer weiteren Windung, vorzugsweise aller weiteren Windungen, des Transformators abhängig. Insbesondere kann der effektive Widerstand die Summe des Windungswiderstands der mindestens einen zu überwachenden Windung und der hin zur Seite der mindestens einen zu überwachenden Windung transformierten Windungswiderstände der weiteren Windungen des Transformators sein. Bildlich gesprochen repräsentiert der effektive Windungswiderstand den Widerstand, den man von den Anschlüssen der mindestens einen zu überwachenden Windungen sieht, wenn man in den Transformator hineinschaut.

Eine effektive Induktivität bezeichnet entsprechend eine Induktivität eines elektrischen Netzwerks zwischen Anschlüssen der mindestens einen zu überwachenden Windung. Die effektive Induktivität zwischen den Anschlüssen ist hierbei zusätzlich zu der Selbstinduktivität der zu überwachenden Windung auch von einer Gegeninduktivität zwischen der mindestens einen zu überwachenden Windung und mindestens einer weiteren Windung des Transformators abhängig. Bildlich gesprochen repräsentiert die effektive Induktivität die Induktivität, die man von den Anschlüssen der mindestens einen zu überwachenden Windungen sieht, wenn kann in den Transformator hineinschaut.

Ein effektiver Widerstand und eine effektive Induktivität sind exemplarisch in Formel 3 durch die Parameter R[ ] und L[ ] bezeichnet.

Die Bestimmung dieser effektiven Parameter ist in vorteilhafter Weise rechentechnisch einfach und zuverlässig zu implementieren und ermöglicht somit eine zuverlässige und robuste Überwachung.

In einer alternativen Ausführungsform wird als zu überwachender Parameter in Abhängigkeit eines dynamischen Strom-Spannungsmodells des Transformators mindestens ein magnetischer Kopplungskoeffizient bestimmt wird, der eine magnetische Kopplung zwischen der mindestens einen zu überwachenden Windung und mindestens einer weiteren Windung des Transformators beschreibt, wobei die Überwachung in Abhängigkeit des mindestens einen magnetischen Kopplungskoeffizienten durchgeführt wird. Dies wurde vorhergehend bereits erläutert.

In einer weiteren Ausführungsform wird/werden in Abhängigkeit des dynamischen Strom-Spannungsmodells des Transformators als zu überwachende(r) Parameter zusätzlich eine Selbstinduktivität der zu überwachenden Windung und/oder ein Windungswiderstand der zu überwachenden Windung bestimmt, wobei die Überwachung zusätzlich in Abhängigkeit der Selbstinduktivität und/oder des Windungswiderstands durchgeführt wird.

Durch die Verwendung dieser zusätzlichen Parameter ergibt sich vorteilhafterweise eine sensiblere und somit verbesserte Überwachung des Zustands des Transformators.

In einer weiteren Ausführungsform wird in Abhängigkeit des dynamischen Strom-Spannungsmodells des Transformators eine geschätzte Windungsspannung der zu überwachenden Windung bestimmt, wobei die/der zu überwachende/n Parameter derart bestimmt wird/werden, dass eine Differenz zwischen der geschätzten Windungsspannung und der realen Windungsspannung minimal ist. Die geschätzte Windungsspannung kann beispielsweise in Abhängigkeit des realen Windungsstromes, der realen Windungsstromänderung, des Windungswiderstandes, der Selbstinduktivität sowie der magnetischen Kopplungskoeffizienten von Kopplungen mit weiteren Windungen sowie den entsprechenden realen Windungsstromänderungen in diesen weiteren Windungen bestimmt werden. Insbesondere kann die geschätzte Windungsspannung auf Grundlage des dynamischen Strom-Spannungsmodells bestimmt werden.

In diesem Fall können die zu überwachenden Parameter der zu überwachenden Windung Variablen eines Optimierungsproblems sein, wobei die Differenz zwischen der geschätzten Windungsspannung und der bestimmten Windungsspannung bzw. die quadratische oder quadrierte Differenz zwischen der geschätzten Windungsspannung und der realen Windungsspannung die so genannte Kostenfunktion des Optimierungsproblems sein kann.

Die Differenz kann hierbei an mehreren aufeinanderfolgenden Zeitpunkten , beispielsweise an mehreren Abtastzeitpunkten, bestimmt werden, wodurch in vorteilhafter Weise mehrere Gleichungen für ein lösbares lineares Gleichungssystem erzeugt werden können. Hierbei reicht bereits die Bestimmung der Differenz an zwei aufeinander folgenden Zeitpunkten.

In einer weiteren Ausführungsform wird in Abhängigkeit des dynamischen Strom-Spannungsmodells des Transformators eine geschätzte Windungsspannung einer ersten zu überwachenden Windung und eine geschätzte Windungsspannung einer weiteren zu überwachenden Windung bestimmt, wobei die zu überwachenden Parameter der ersten und weiteren zu überwachenden Windung derart bestimmt werden, dass eine Differenz zwischen den geschätzten Windungsspannungen der ersten zu überwachenden Windung und der weiteren zu überwachenden Windung minimal ist. Hierbei bildet also die Differenz zwischen den geschätzten Windungsspannungen der ersten und der weiteren zu überwachenden Windung bzw. eine quadratische oder quadrierte Differenz zwischen den geschätzten Windungsspannungen die Kostenfunktion eines Optimierungsproblems, wobei die zu überwachenden Parameter wiederum Variablen des Optimierungsproblems sind.

Umfasst der Transformator mehr als zwei Windungen, so kann es notwendig sein, dass auch reale Windungsströme oder reale Windungsstromänderungen von verbleibenden, nicht überwachten Windungen, bestimmt, beispielsweise direkt gemessen oder indirekt berechnet, werden.

Die in der erläuterten Ausführungsform zu bestimmenden Parameter umfassen also zumindest den magnetischen Kopplungskoeffizienten zwischen der ersten und der weiteren zu überwachenden Windung. Weiter können die zu bestimmenden Parameter die Selbstinduktivitäten der zu überwachenden Windungen sowie die Windungswiderstände der zu überwachenden Windungen umfassen. Sind mehr Windungen als die zu überwachenden Windungen im Transformator enthalten, so können die zu bestimmenden Parameter auch die magnetischen Kopplungskoeffizienten der zu überwachenden Windungen mit den nicht überwachten Windungen umfassen.

In einer bevorzugten Ausführungsform wird eine Bestimmung der zu überwachenden Parameter der ersten und weiteren zu überwachenden Windungen in Abhängigkeit eines vorbekannten Windungszahlverhältnisses zwischen der ersten und der weiteren zu überwachenden Windung durchgeführt. Umfasst der Transformator mehr als die zu überwachenden Windungen, so kann die Bestimmung der Parameter zusätzlich in Abhängigkeit von weiteren vorbekannten Windungszahlverhältnissen durchgeführt werden, die die jeweiligen Windungszahlverhältnisse zwischen den Windungen des Transformators beschreiben.

Das/die vorbekannte/n Windungszahlverhältnis/se kann/können hierbei beispielsweise das/die ideale/n Windungszahlverhältnis/se in einem fehlerfreien Zustand des Transformators oder das/die Windungszahlverhältnis/se des Transformators gemäß einer Spezifikation des Transformators sein.

Hierdurch ergibt sich in vorteilhafter Weise eine erhebliche Vereinfachung der Berechnung bzw. Bestimmung der zu überwachenden Parameter, da z. B. ein realer Windungsstrom der ersten zu überwachenden Windung in Abhängigkeit eines realen Windungsstromes der weiteren zu überwachenden Windung ausgedrückt werden kann. In diesem Fall kann also der reale Windungsstrom der ersten Windung in Abhängigkeit des direkt erfassten Windungsstroms der weiteren Windung indirekt berechnet werden. Es ist also nicht erforderlich, den Windungsstrom der ersten zu überwachenden Windung direkt zu erfassen, beispielsweise zu messen.

Einer weiteren Ausführungsform ist die erste zu überwachende Windung eine Primärwindung des Transformators und die weitere zu überwachende Windung eine Sekundärwindung des Transformators. Es ist auch vorstellbar, dass die erste zu überwachende Windung eine erste Sekundärwindung und die weitere zu überwachende Windung eine weitere Sekundärwindung des Transformators ist.

Hierdurch ergibt sich in vorteilhafter Weise eine flexible Überwachung unterschiedlicher Windungen des Transformators.

In einer weiteren Ausführungsform wird in Abhängigkeit des dynamischen Strom-Spannungsmodells des Transformators als erster Term eine Differenz zwischen einer geschätzten Windungsspannung der mindestens einen zu überwachenden Windung und einer geschätzten Windungsspannung einer weiteren Windung des Transformators bestimmt. Die weitere Windung kann hierbei eine weitere zu überwachende Windung sein. Die Differenz kann in Abhängigkeit des/der zu überwachenden Parameter, insbesondere in Abhängigkeit des vorhergehend erläuterten effektiven Widerstands und der effektiven Induktivität, bestimmt werden (siehe z.B. Formel 3). Auch ist es möglich, in Abhängigkeit des dynamischen Strom-Spannungsmodells des Transformators die geschätzte Windungsspannung der mindestens einen zu überwachenden Windung und die geschätzte Windungsspannung der weiteren Windung und danach die Differenz zu bestimmen.

Weiter wird als zweiter Term die Differenz zwischen einer realen Windungsspannung der mindestens einen zu überwachenden Windung und der realen Windungsspannung der weiteren Windung des Transformators bestimmt. Beispielsweise kann die reale Windungsspannung der mindestens einen zu überwachenden Windung und die reale Windungsspannung der weiteren Windung und danach die Differenz bestimmt werden.

Der/die zu überwachende(n) Parameter wird/werden derart bestimmt, dass eine Differenz zwischen dem zweiten Term und dem ersten Term minimal ist. Der erste Term kann also auch als Subtrahend und der zweite Term als Minuend bezeichnet werden.

Hierbei kann also die Differenz bzw. eine quadratische oder quadrierte Differenz zwischen der Differenz zwischen den realen Windungsspannungen und der Differenz zwischen den geschätzten Windungsspannungen die Kostenfunktion eines Optimierungsproblems bilden, wobei die zu überwachenden Parameter wiederum Variablen des Optimierungsproblems sind. Dieses Optimierungsproblem kann z.B. durch ein Least-Squares-Verfahren gelöst werden, wodurch eine einfache, explizite und ausschließlich in Abhängigkeit von algebraischen Operationen durchführbare Bestimmung des/der zu überwachenden Parameter möglich ist.

Auch in dieser Ausführungsform kann eine Bestimmung der zu überwachenden Parameter in Abhängigkeit eines vorbekannten Windungszahlverhältnisses zwischen der mindestens einen zu überwachenden und der weiteren Windung durchgeführt werden. Weiter kann die mindestens eine zu überwachende Windung eine Primärwindung des Transformators und die weitere Windung eine Sekundärwindung des Transformators sein. Selbstverständlich sind auch die umgekehrte Konstellation oder Konstellationen mit weiteren (Sekundär)Windungen vorstellbar.

In einer weiteren Ausführungsform umfasst der Transformator mehr als zwei Windungen, wobei eine Überwachung für jede der Windungen durchgeführt wird. Hierbei kann z. B. ein realer Windungsstrom, eine reale Windungsstromänderung und eine reale Windungsspannung für jede der Windungen direkt erfasst, beispielsweise gemessen, oder indirekt berechnet werden. In Abhängigkeit dieser realen Größen können dann z. B. geschätzte Windungsspannungen, insbesondere in Abhängigkeit des dynamischen Strom-Spannungs-Modells, berechnet oder geschätzt werden, wobei in Abhängigkeit dieser geschätzten Windungsspannungen dann die zu überwachenden Parameter im Rahmen der Lösung eines Optimierungsproblems bestimmt werden können.

Hierdurch ergibt sich in vorteilhafter Weise eine einfache und effektive Überwachung aller Windungen eines Transformators.

In einer weiteren Ausführungsform wird eine Überwachung in Abhängigkeit einer Differenz zwischen mindestens einem erfindungsgemäß bestimmten Parameter und einem korrespondierenden Referenzparameter durchgeführt. Der korrespondierende Referenzparameter kann beispielsweise der entsprechende Parameter in einem fehlerfreien Zustand des Transformators sein, der beispielsweise in einem Testlauf bestimmt wurde. Ist die Differenz größer als ein vorbestimmter Schwellwert, so kann ein Warn- oder Fehlersignal erzeugt werden, wodurch z. B. ein Benutzer gewarnt werden kann und/oder ein Betrieb des Transformators in geeigneter Weise angepasst, beispielsweise beendet, werden kann.

Alternativ kann die Überwachung in Abhängigkeit einer Differenz zwischen einem ersten erfindungsgemäß bestimmten Parameter und mindestens einem weiteren erfindungsgemäß bestimmten Parameter durchgeführt werden. Z. B. kann bei einem symmetrisch aufgebauten Transformator, bei dem beispielsweise die Windungszahl einer Primärwindung der Windungszahl einer Sekundärwindung entspricht, der Kopplungskoeffizient, der die magnetische Kopplung zwischen der Primärwindung und der Sekundärwindung beschreibt, gleich dem magnetischen Kopplungskoeffizient, der die magnetische Kopplung der Sekundärwindung mit der Primärwindung beschreibt, sein. Überschreitet die Differenz dieser erfindungsgemäß bestimmten Kopplungskoeffizienten z. B. einen vorbestimmten Schwellwert, so kann, entsprechend den vorhergehenden Ausführungen, ein Warn- oder Fehlersignal ausgegeben werden.

Alternativ kann die Überwachung in Abhängigkeit einer Differenz zwischen einem zu einem ersten Zeitpunkt erfindungsgemäß bestimmten Parameter und einem zu einem späteren Zeitpunkt erfindungsgemäß bestimmten korrespondierenden Parameter durchgeführt werden. Hierdurch können z. B. zeitliche Änderungen eines erfindungsgemäß zu verschiedenen Zeitpunkten bestimmten Parameters detektiert werden. Übersteigt die Differenz z. B. einen vorbestimmten Schwellwert, so kann, wie vorhergehend erläutert, ein Warn- oder Fehlersignal erzeugt werden.

Hierdurch ergibt sich in vorteilhafter Weise eine einfache und zuverlässige Erzeugung eines Warn- oder Fehlersignals.

Weiter vorgeschlagen wird eine Vorrichtung zur Überwachung eines Transformators, insbesondere zur Überwachung mindestens eines Windungszahlverhältnisses des Transformators. Die Vorrichtung umfasst ein Mittel zur Bestimmung eines realen Windungsstromes mindestens einer zu überwachenden Windung, ein Mittel zur Bestimmung einer realen Windungsstromänderung der mindestens einen zu überwachenden Windung, ein Mittel zur Bestimmung einer realen Windungsspannung der mindestens einen zu überwachenden Windung und eine Auswerteeinrichtung. Die Mittel zur Bestimmung des realen Windungsstromes, der realen Windungsstromänderung und der realen Windungsspannung können hierbei zumindest teilweise integriert oder separat ausgebildet sein. Beispielsweise können die Mittel als Sensoren zur Erfassung der entsprechenden realen Größe, beispielsweise des realen Windungsstromes, ausgebildet sein.

Erfindungsgemäß ist mittels der Auswerteeinrichtung als zu überwachende(r) Parameter in Abhängigkeit eines dynamischen Strom-Spannungsmodells des Transformators mindestens ein von einem Windungswiderstand der mindestens einen zu überwachenden Windung abhängiger Parameter und mindestens ein von einer Selbstinduktivität und einer Gegeninduktivität der mindestens einen zu überwachenden Windung abhängiger Parameter bestimmbar, wobei die Überwachung in Abhängigkeit des mindestens einen zu überwachenden Parameters durchführbar ist.

Wie vorhergehend bereits erläutert ist durch diese vorgeschlagene Ausführungsform auch eine Vorrichtung zur Überwachung eines Zustands eines Transformators beschrieben, wobei die Vorrichtung ein Mittel zur Bestimmung eines realen Windungsstroms mindestens einer zu überwachenden Windung, ein Mittel zur Bestimmung einer realen Windungsstromänderung der mindestens einen zu überwachenden Windung, ein Mittel zur Bestimmung einer realen Windungsspannung der mindestens einen zu überwachenden Windung und eine Auswerteeinrichtung umfasst, wobei mittels der Auswerteeinrichtung mindestens ein zu überwachender Parameter des Transformators bestimmbar ist. Weiter ist mittels der Auswerteeinrichtung in Abhängigkeit eines dynamischen Strom-Spannungsmodells des Transformators als zu überwachender Parameter mindestens ein magnetischer Kopplungskoeffizient bestimmbar, der eine magnetische Kopplung zwischen der zu überwachenden Windung und mindestens einer weiteren Windung des Transformators beschreibt. Mittels der Auswerteeinrichtung ist weiter die Überwachung in Abhängigkeit des mindestens einen magnetischen Kopplungskoeffizienten durchführbar.

Hierbei kann die vorgeschlagene Vorrichtung auch Mittel zur Bestimmung eines realen Windungsstromes und/oder einer realen Windungsstromänderung der mindestens einen weiteren Windung oder aller weiteren Windungen des Transformators umfassen.

Hierdurch ergibt sich in vorteilhafter Weise eine Vorrichtung mittels derer die vorhergehend beschriebenen Verfahren zur Überwachung des Zustandes des Transformators durchführbar sind.

In einer weiteren Ausführungsform ist/sind mittels der Auswerteeinrichtung als zu überwachende(r) Parameter ein effektiver Widerstand und/oder eine effektive Induktivität der mindestens einen zu überwachenden Windung bestimmbar. Dies ermöglicht in vorteilhafter Weise eine rechentechnisch einfache und zuverlässige Bestimmung des/der zu überwachenden Parameter und ermöglicht somit eine zuverlässige und robuste Überwachung.

In einer weiteren Ausführungsform ist/sind mittels der Auswerteeinrichtung als zu überwachende(r) Parameter zusätzlich eine Selbstinduktivität der zu überwachenden Windung und/oder ein Windungswiderstand der zu überwachenden Windung bestimmbar, indem eine Minimierung einer Differenz bzw. einer quadratischen oder quadrierten Differenz zwischen einer geschätzten Windungsspannung der zu überwachenden Windung und der realen Windungsspannung der zu überwachenden Windung oder eine Minimierung einer Differenz bzw. einer quadratischen oder quadrierten Differenz zwischen einer geschätzten Windungsspannung einer ersten zu überwachenden Windung und einer geschätzten Windungsspannung einer weiteren zu überwachenden Windung durchführbar ist.

Hierdurch ergibt sich in vorteilhafter Weise eine Vorrichtung mittels derer eine einfache Überwachung des Zustands des Parameters des Transformators durchführbar ist.

Weiter beschrieben wird ein Computerprogrammprodukt in oder auf welchem ein Code zur Ausführung eines der vorhergehend erläuterten Verfahren gespeichert ist. Insbesondere kann das Computerprogrammprodukt ein Computerprogramm enthalten, welches Softwaremittel zur Durchführung eines der vorhergehend erläuterten Verfahren aufweist, wenn das Computerprogramm in einem Automatisierungssystem ausgeführt wird.

Die Erfindung wird anhand zweier Ausführungsbeispiele näher erläutert. Die Figuren zeigen:

Fig. 1     eine schematische Darstellung eines ersten Transformators und

Fig. 2     eine schematische Darstellung einer Schaltungsanordnung mit einer Vorrichtung zur Überwachung eines Zustands eines weiteren Transformators

Nachfolgend bezeichnen gleiche Bezugszeichen Elemente mit gleichen oder ähnlichen technischen Merkmalen.

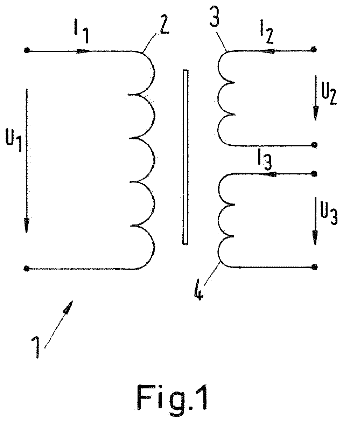

In Fig. 1 ist ein schematisches Schaltbild eines Transformators 1 dargestellt. Der Transformator 1 umfasst eine Primärwindung 2, eine erste Sekundärwindung 3 und eine zweite Sekundärwindung 4. Ein realer Windungsstrom der Primärwindung ist mit $I_1$, und eine reale Windungsspannung der Primärwindung mit $U_1$ bezeichnet. Entsprechend sind realen Windungsströme und realen Windungsspannungen der Sekundärwindungen 3, 4 mit $I_2$, $U_2$, $I_3$, $U_3$ bezeichnet.

Ein dynamisches Strom-Spannungsmodell des Transformators 1 kann über die folgende Gleichung ausgedrückt werden:

$$\tilde{U}_i = I_i \times R_i + L_i \times dI_i/dt + \Sigma^n_{k=1,\, k\neq i}\ (m_{ik} \times dI_k/dt) \text{ für } i=1,\ \ldots,\ n \qquad\qquad \text{Formel 1}$$

wobei $\tilde{U}_i$ die geschätzte Windungsspannung der i-ten Windung, $I_i$ den realen Windungsstrom der i-ten Windung, $R_i$ einen Windungswiderstand der i-ten Windung, $L_i$ eine Selbstinduktivität der i-ten Windung, $m_{ik}$ einen magnetischen Kopplungskoeffizienten bzw. eine Gegeninduktivität zwischen der i-ten Windung und der k-ten Windung, $I_k$ einen realen Windungsstrom der k-ten Windung und n die Anzahl der Primär- und Sekundärwindungen, in diesem Fall Drei, beschreibt. Entsprechend Formel 1 kann somit eine geschätzte Windungsspannung $\tilde{U}_1$ der Primärwindung 2, eine geschätzte Windungsspannung $\tilde{U}_2$ der ersten Sekundär-windung 3 und eine geschätze Windungsspannung $\tilde{U}_3$ der zweiten Sekundärwindung 4 geschätzt werden. Werden die entsprechenden realen Windungsspannungen $U_1$, $U_2$, $U_3$ ebenfalls gemessen, z. B. mittels geeigneter Spannungssensoren, so ergibt sich ein Fehler als

$$e_i = \tilde{U}_i - U_i = (I_i \times R_i + L_i \times dI_i/dt + \Sigma^n_{k=1,\, k\neq i}\ (m_{ik} \times dI_k/dt)) - U_i \qquad\qquad \text{Formel 2}$$

wobei $U_i$ die reale, beispielsweise gemessene, Windungsspannung der i-ten Windung bezeichnet. Die Parameter $R_i$, $L_i$, $m_{ik}$ können bestimmt werden, indem z. B. der in Formel 2 beschriebene Fehler $e_i$ quadriert wird und die Parameter derart bestimmt werden, dass dieser quadrierte Fehler $e_i$ über einen vorbestimmten Zeitraum minimiert wird. Beispielsweise können über den vorbestimmten Zeitraum an einer Anzahl von Abtastzeitpunkten jeweils die realen Windungsspannungen $U_i$ erfasst und somit der quadrierte Fehler $e_i$ bestimmt werden, wobei die Parameter derart bestimmt werden, dass die Summe der quadrierten Fehler $e_i$ minimal wird.

Die derart bestimmten Parameter $R_i$, $L_i$, $m_{ik}$ können dann z. B. mit vorbestimmten Referenzparametern verglichen werden, wobei diese z. B. in Vorabversuchen für den in Fig. 1 dargestellten Transformator 1 bestimmt werden. Ergeben sich Abweichungen, die z. B. größer als ein vorbestimmter Schwellwert sind, so kann ein Warn- oder Fehlersignal erzeugt werden.

Wird davon ausgegangen, dass eine Windungszahl der ersten Sekundärwindung 3 gleich einer Windungszahl der zweiten Sekundärwindung 4 ist, so können die derart bestimmten Parameter auch untereinander verglichen werden. Z. B. kann eine Differenz des magnetischen Kopplungskoeffizienten $m_{12}$ mit einem magnetischen Kopplungskoeffizienten $m_{13}$ verglichen werden, wobei diese Kopplungskoeffizienten $m_{12}$, $m_{13}$ die magnetische Kopplung der Primärwindung 2 mit der ersten Sekundärwindung 3 bzw. mit der zweiten Sekundärwindung 4 beschreiben. Weichen diese um einen vorbestimmtes Maß voneinander ab, ist beispielsweise eine Differenz dieser Kopplungskoeffizienten $m_{12}$, $m_{13}$ größer als ein vorbestimmter Schwellwert, so kann ein Warn- oder Fehlersignal erzeugt werden.

Das Optimierungsproblem kann jedoch noch weiter vereinfacht werden. Ist z. B. ein vorbestimmtes Windungszahlverhältnis zwischen der Primärwindung 2 und der ersten Sekundärwindung 3 sowie der Primärwindung 2 und der zweiten Sekundärwindung 4 bekannt, so kann eine Differenz der geschätzten Windungsspannung $\tilde{U}_1$ der Primärwindung 2 und der geschätzten Windungsspannung $\tilde{U}_2$ der ersten Sekundärwindung 3 wie folgt ausgedrückt werden:

$$\tilde{U}_1 - \tilde{U}_2 = [(R_1 \times k_2 - R_2) \times I_2\ ]+$$
$$[L_1 \times k_2 - L_2 + (1 - k_2) \times m_{12} + k_2/k_3 \times (m_{13} - m_{23})] \times dI_2/dt =$$
$$R[\ ] \times I_2 + L[\ ] \times dI_2/dt \qquad \text{Formel 3}$$

wobei $k_2$ das Windungszahlverhältnis der Windungszahl der Primärwindung 2 zur Windungszahl der ersten Sekundärwindung 3 und $k_3$ das Windungszahlverhältnis der Windungszahl der Primärwindung 2 zur Windungszahl der zweiten Sekundärwindung 4 beschreibt. Hierdurch können in vorteilhafter Weise die zu überwachenden Parameter $R_1$, $R_2$, $L_1$, $L_2$, $m_{12}$, $m_{13}$, $m_{23}$ in Abhängigkeit einer einzigen Gleichung bestimmt werden, wodurch sich eine Bestimmung der Parameter rechentechnisch vereinfacht.

Somit ist

$$R[\ ] = [(R_1 \times k_2 - R_2) \text{ und } L[\ ] = L_1 \times k_2 - L_2 + (1 - k_2) \times m_{12} + k_2/k_3 \times (m_{13} - m_{23}).$$

Auch ist es möglich, dass der Term R[ ] als von der ersten Sekundärwindung 3 aus gesehener Gesamtwiderstand des Transformators und der Ausdruck L[ ] als von der ersten Sekundärwindung 3 aus gesehene Gesamtinduktivität des Transformators 1 zusammengefasst wird. Hierbei kann eine Überwachung auch in Abhängigkeit dieses Gesamtwiderstandes R[] und der Gesamtinduktivität L[] durchgeführt werden.

Insbesondere kann ein Fehler in diesem Fall als

$$e = U_1 - U_2 - (R[\ ] \times I_2 + L[\ ] \times dI_2/dt) \qquad \text{Formel 4}$$

ausgedrückt werden, wobei $U_1$ und $U_2$ jeweils die realen, z.B. gemessenen, Windungsspannungen an der Primärwindung 2 bzw. an der ersten Sekundärwindung 3 beschreiben. Ist ein Messwert einer oder beider Windungsspannung(en) $U_1$, $U_2$ nicht verfügbar, so kann auch ein Sollwert der Windungsspannung(en) $U_1$, $U_2$, der/die z.B. durch einen entsprechenden Regler bestimmt wird/werden, verwendet werden.

Wie vorhergehend beschrieben, können die zu überwachenden Parameter durch eine Minimierung des in Formel 4 beschriebenen quadrierten Fehlers e über einen vorbestimmten Zeitraum bestimmt werden.

Es ist möglich, ein derartiges Optimierungsproblem durch eine Diskretisierung durchzuführen. So kann z. B. der in Formel 4 gegebene Ausdruck in diskreter Form wie folgt dargestellt werden:

$$U_{1,t} - U_{2,t} = R[\ ] \times I_{2,t} + L[\ ] \times \Delta I_{2,t} \qquad \text{Formel 5}$$

wobei R[] und L[] der vorhergehend erwähnte Gesamtwiderstand bzw. die vorhergehend erwähnte Gesamtinduktivität bezeichnen und $\Delta I_{2,t}$ gleich

$$\Delta I_{2,t} = (I_{2,t-1} - I_{2,t+1})/(2 \times \Delta t) \qquad \text{Formel 6}$$

ist, wobei $U_{i,t}$ die zum Abtastzeitpunkt t reale Windungsspannung an der i-ten Windung, $I_{i,t}$ den zum Abtastzeitpunkt t realen Windungsstrom durch die i-te Windung und $\Delta t$ eine Abtastrate bezeichnet. Werden an mehreren Abtastzeitpunkten t die in Formel 5 angegebenen Windungsspannungen $U_{1,t}$, $U_{2,t}$ sowie der in Formel 5 angegebene Windungsstrom $I_{2,t}$ der ersten Sekundärwindung 3 erfasst, so kann ein lineares Gleichungssystem erstellt werden, wobei die zu überwachenden Parameter als Lösung des linearen Gleichungssystems bestimmt werden können. Die Lösung des linearen

Gleichungssystems kann beispielsweise als so genannte Least-Squares-Lösung bestimmt werden. Auf gleiche Art und Weise können selbstverständlich auch zu überwachende Parameter der zweiten Sekundärwindung 4 bestimmt werden.

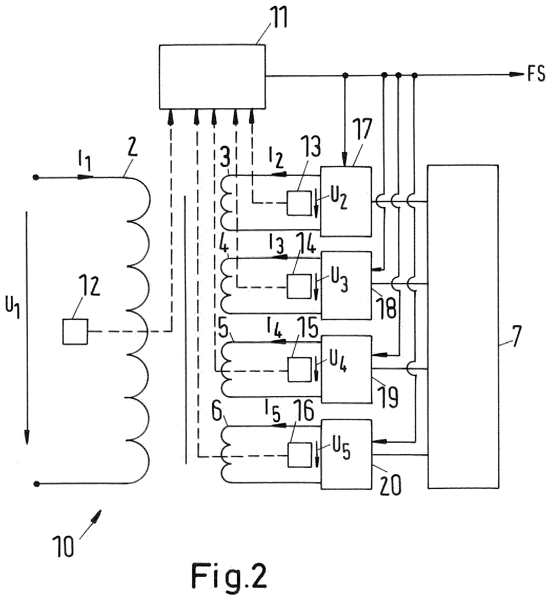

In Fig. 2 ist eine Schaltungsanordnung 10 dargestellt, die einen Transformator mit einer Primärwindung 2 und vier Sekundärwindungen 3, 4, 5, 6 umfasst. Die Schaltungsanordnung umfasst weiter eine Auswerteeinrichtung 11, die signaltechnisch mit Sensorelementen 12, die eine reale Windungsspannung $U_1$ und einen realen Windungsstrom $I_1$ der

Primärwindung 2 erfassen, sowie mit Sensorelementen 13, 14, 15, 16, die jeweils reale Windungsspannungen $U_2$, $U_3$, $U_4$, $U_5$ sowie reale Windungsströme $I_2$, $I_3$, $I_4$, $I_5$ der Sekundärwindungen 3, 4, 5, 6 erfasst, verbunden ist. Die Auswerteeinrichtung 11 dient gleichzeitig als Steuereinrichtung für einen ersten Gleichrichter 17, der an die erste Sekundärwindung 3 angeschlossen ist, einen zweiten Gleichrichter 18, der an die zweite Sekundärwindung 4 angeschlossen ist, einen dritten Gleichrichter 19, der an die dritte Sekundärwindung 5 angeschlossen ist und einen vierten Gleichrichter 20, der an die vierte Sekundärwindung 6 angeschlossen ist. In Fig. 2 ist dargestellt, dass an die Gleichrichter 17, 18, 19, 20 eine Last 7 angeschlossen ist. Die in Fig. 2 dargestellte Auswerteeinrichtung 11 kann hierbei, wie vorhergehend in der Beschreibung zu Fig. 1 erläutert, Parameter der Primärwindung 2 sowie der Sekundärwindungen 3, 4, 5, 6 überwachen, z. B. indem Parameter bestimmt und mit Referenzparametern verglichen werden. Im Falle eines unerwünschten Abweichens, z. B. falls ein vorbestimmter Schwellwert überschritten wird, kann ein Fehlersignal FS erzeugt und z. B. an eine Anzeigeeinrichtung übertragen werden.

Eine Sensitivität und/oder eine Genauigkeit des vorgeschlagenen Verfahrens kann hierbei z. B. durch eine Veränderung einer Länge des vorbestimmten Zeitraumes, über den der vorhergehend erläuterte Fehler minimiert wird, erfolgen. Auch kann die Sensitivität und/oder Genauigkeit über eine Anpassung von Schwellwerten für die Abweichung bzw. Differenz zwischen Referenzparametern und den mittels des vorgeschlagenen Verfahrens bestimmten Parametern erfolgen.

**Patentansprüche**

1. Verfahren zur Überwachung eines Zustands eines Transformators (1), wobei ein realer Windungsstrom ($I_1$, $I_2$, $I_3$, $I_4$, $I_5$) mindestens einer zu überwachenden Windung, eine reale Windungsstromänderung der mindestens einen zu überwachenden Windung und eine reale Windungsspannung ($U_1$, $U_2$, $U_3$, $U_4$, $U_5$) der mindestens einen zu überwachenden Windung bestimmt wird, wobei der reale Windungsstrom ($I_1$, $I_2$, $I_3$, $I_4$, $I_5$), die reale Windungsstromänderung und die reale Windungsspannung sich physikalisch in/an der mindestens einen zu überwachenden Windung einstellt, wobei mehrere zu überwachende Parameter des Transformators (1) bestimmt werden,
   **dadurch gekennzeichnet, dass**
   der Transformator (1) eine Primärwicklung (2) und mehrere Sekundärwicklungen (3, 4, 5, 6) umfasst, wobei als zu überwachende Parameter in Abhängigkeit eines dynamischen Strom-Spannungsmodells des Transformators (1) mindestens ein Parameter, der von einem Windungswiderstand der mindestens einen zu überwachenden Windung abhängig ist, und mindestens ein Parameter, der von einer Selbstinduktivität und einer Gegeninduktivität der mindestens einen zu überwachenden Windung abhängig ist, bestimmt werden, wobei die Überwachung in Abhängigkeit der zu überwachenden Parameter durchgeführt wird.

2. Verfahren nach Anspruch 1, **dadurch gekennzeichnet, dass** als zu überwachende/r Parameter ein effektiver Widerstand und/oder eine effektive Induktivität der mindestens einen zu überwachenden Windung bestimmt wird, wobei der effektive Widerstand die Summe des Windungswiderstands der mindestens einen zu überwachenden Windung und der hin zur Seite der mindestens einen zu überwachenden Windung transformierten Windungswiderstände der weiteren Windungen des Transformators ist, wobei die effektive Induktivität zusätzlich zu der Selbstinduktivität der zu überwachenden Windung auch von einer Gegeninduktivität zwischen der mindestens einen zu überwachenden Windung und mindestens einer weiteren Windung des Transformators abhängig ist.

3. Verfahren nach Anspruch 1, **dadurch gekennzeichnet, dass** als zu überwachender Parameter in Abhängigkeit eines dynamischen Strom-Spannungsmodells des Transformators (1) mindestens ein magnetischer Kopplungskoeffizient bestimmt wird, der eine magnetische Kopplung zwischen der mindestens einen zu überwachenden Windung und mindestens einer weiteren Windung des Transformators (1) beschreibt, wobei die Überwachung in Abhängigkeit des mindestens einen magnetischen Kopplungskoeffizienten durchgeführt wird.

4. Verfahren nach Anspruch 3, **dadurch gekennzeichnet, dass** in Abhängigkeit des dynamischen Strom-Spannungsmodells des Transformators (1) als zu überwachende/r Parameter zusätzlich eine Selbstinduktivität der zu überwachenden Windung und/oder ein Windungswiderstand der zur überwachenden Windung bestimmt wird/werden, wobei die Überwachung zusätzlich in Abhängigkeit der Selbstinduktivität und/oder des Windungswiderstands durchgeführt wird.

5. Verfahren nach einem der Ansprüche 1 bis 4, **dadurch gekennzeichnet, dass** in Abhängigkeit des dynamischen Strom-Spannungsmodells des Transformators (1) eine geschätzte Windungsspannung der zu überwachenden Windung bestimmt wird, wobei die/der zu überwachende/n Parameter derart bestimmt wird/werden, dass eine Differenz zwischen der geschätzten Windungsspannung und der realen Windungsspannung ($U_1$, $U_2$, $U_3$, $U_4$, $U_5$) minimal ist.

6. Verfahren nach einem der Ansprüche 1 bis 4, **dadurch gekennzeichnet, dass** in Abhängigkeit des dynamischen Strom-Spannungsmodells des Transformators (1) eine geschätzte Windungsspannung einer ersten zu überwachenden Windung und eine geschätzte Windungsspannung einer weiteren zu überwachenden Windung bestimmt wird, wobei die zu überwachenden Parameter der ersten und weiteren zu überwachenden Windung derart bestimmt werden, dass eine Differenz zwischen den geschätzten Windungsspannungen der ersten zu überwachenden Windung und der weiteren zu überwachenden Windung minimal ist.

7. Verfahren nach Anspruch 6, **dadurch gekennzeichnet, dass** eine Bestimmung der zu überwachenden Parameter der ersten und weiteren zu überwachenden Windung in Abhängigkeit eines vorbekannten Windungszahlverhältnis zwischen der ersten und der weiteren zu überwachenden Windung durchgeführt wird.

8. Verfahren nach einem der Ansprüche 6 oder 7, **dadurch gekennzeichnet, dass** die erste zu überwachende Windung eine Primärwindung (2) des Transformators (1) und die weitere zu überwachende Windung eine Sekundärwindung (3, 4, 5, 6) des Transformators ist.

9. Verfahren nach einem der Ansprüche 1 bis 4, **dadurch gekennzeichnet, dass** in Abhängigkeit des dynamischen Strom-Spannungsmodells des Transformators (1) als erster Term eine Differenz zwischen einer geschätzten Windungsspannung der mindestens einen zu überwachenden Windung und einer geschätzten Windungsspannung einer weiteren Windung des Transformators bestimmt wird, wobei als zweiter Term eine Differenz zwischen der realen Windungsspannung der mindestens einen zu überwachenden Windung und der realen Windungsspannung der weiteren Windung des Transformators bestimmt wird, wobei der/die zu überwachende(n) Parameter derart bestimmt wird/werden, dass eine Differenz zwischen dem zweiten Term und dem ersten Term minimal ist.

10. Verfahren nach einem der Ansprüche 1 bis 9, **dadurch gekennzeichnet, dass** der Transformator (1) mehr als zwei Windungen (2, 3, 4, 5, 6) umfasst, wobei eine Überwachung für jede der Windungen (2, 3, 4, 5, 6) durchgeführt wird.

11. Verfahren nach einem der Ansprüche 1 bis 10, **dadurch gekennzeichnet, dass** eine Überwachung in Abhängigkeit einer Differenz zwischen mindestens einem zu überwachenden Parameter und einem korrespondierenden Referenzparameter oder in Abhängigkeit einer Differenz zwischen einem ersten zu überwachenden Parameter und mindestens einem weiteren zu überwachenden Parameter oder in Abhängigkeit einer Differenz zwischen einem zu einem ersten Zeitpunkt bestimmten Parameter und einem zu einem späteren Zeitpunkt bestimmten korrespondierenden Parameter durchgeführt wird.

12. Vorrichtung zur Überwachung eines Zustands eines Transformators (1), wobei die Vorrichtung ein Mittel zur Bestimmung eines realen Windungsstroms ($I_1$, $I_2$, $I_3$, $I_4$, $I_5$) mindestens einer zu überwachenden Windung, ein Mittel zur Bestimmung einer realen Windungsstromänderung der mindestens einen zu überwachenden Windung, ein Mittel zur Bestimmung einer realen Windungsspannung ($U_1$, $U_2$, $U_3$, $U_4$, $U_5$) der mindestens einen zu überwachenden Windung und eine Auswerteeinrichtung (11) umfasst, wobei mittels der Auswerteeinrichtung (11) mehrere zu überwachende Parameter des Transformators bestimmbar sind, wobei der reale Windungsstrom ($I_1$, $I_2$, $I_3$, $I_4$, $I_5$), die reale Windungsstromänderung und die reale Windungsspannung sich physikalisch in/an der mindestens einen zu überwachenden Windung einstellt,
**dadurch gekennzeichnet, dass**
der Transformator (1) eine Primärwicklung (2) und mehrere Sekundärwicklungen (3, 4, 5, 6) umfasst, wobei mittels der Auswerteeinrichtung (11) als zu überwachende Parameter in Abhängigkeit eines dynamischen Strom-Spannungsmodells des Transformators (1) mindestens ein Parameter, der von einem Windungswiderstand der mindestens einen zu überwachenden Windung abhängig ist, und mindestens ein Parameter, der von einer Selbstinduktivität und einer Gegeninduktivität der mindestens einen zu überwachenden Windung abhängig ist, bestimmbar sind, wobei die Überwachung in Abhängigkeit der zu überwachenden Parameter durchführbar ist.

13. Vorrichtung nach Anspruch 12, **dadurch gekennzeichnet, dass** mittels der Auswerteeinrichtung (11) als zu überwachende/r Parameter ein effektiver Widerstand und/oder eine effektive Induktivität der mindestens einen zu überwachenden Windung bestimmbar ist, wobei der effektive Widerstand die Summe des Windungswiderstands der mindestens einen zu überwachenden Windung und der hin zur Seite der mindestens einen zu überwachenden Windung transformierten Windungswiderstände der weiteren Windungen des Transformators ist, wobei die effektive Induktivität zusätzlich zu der Selbstinduktivität der zu überwachenden Windung auch von einer Gegeninduktivität zwischen der mindestens einen zu überwachenden Windung und mindestens einer weiteren Windung des Transformators abhängig ist.

**14.** Vorrichtung nach Anspruch 12, **dadurch gekennzeichnet, dass** mittels der Auswerteeinrichtung (11) in Abhängigkeit eines dynamischen Strom-Spannungsmodells des Transformators (1) als zu überwachender Parameter mindestens ein magnetischer Kopplungskoeffizient bestimmbar ist, der eine magnetische Kopplung zwischen der mindestens einen zu überwachenden Windung und mindestens einer weiteren Windung des Transformators (1) beschreibt, wobei mittels der Auswerteeinrichtung (11) die Überwachung in Abhängigkeit des mindestens einen magnetischen Kopplungskoeffizienten durchführbar ist.

**15.** Vorrichtung nach Anspruch 14, **dadurch gekennzeichnet, dass** mittels der Auswerteeinrichtung (11) als zu überwachende/r Parameter zusätzlich eine Selbstinduktivität der zu überwachenden Windung und/oder ein Windungswiderstand der zur überwachenden Windung bestimmbar ist, indem eine Minimierung einer Differenz zwischen einer geschätzten Windungsspannung der zu überwachenden Windung und der realen Windungsspannung der zu überwachenden Windung oder eine Minimierung einer Differenz zwischen einer geschätzten Windungsspannung einer ersten zu überwachenden Windung und einer geschätzten Windungsspannung einer weiteren zu überwachenden Windung durchführbar ist.

## Claims

**1.** A method for monitoring a state of a transformer (1), wherein an actual winding current ($I_1$, $I_2$, $I_3$, $I_4$, $I_5$) of at least one winding to be monitored, an actual winding current change of the at least one winding to be monitored, and an actual winding voltage ($U_1$, $U_2$, $U_3$, $U_4$, $U_5$) of the at least one winding to be monitored is determined, the actual winding current ($I_1$, $I_2$, $I_3$, $I_4$, $I_5$), the actual winding current change, and the actual winding voltage arising physically in/at the at least one winding to be monitored, wherein a plurality of parameters of the transformer (1) to be monitored is determined, **characterized in that**
the transformer (1) comprises a primary winding (2) and a plurality of secondary windings (3, 4, 5, 6), wherein, as a function of a dynamic current-voltage model of the transformer (1), at least one parameter that is dependent on a winding resistance of the at least one winding to be monitored and at least one parameter that is dependent on a self-inductance and a mutual inductance of the at least one winding to be monitored are determined as parameters to be monitored, wherein the monitoring is carried out depending on the parameters to be monitored.

**2.** The method according to claim 1, **characterized in that** an effective resistance and/or an effective inductance of the at least one winding to be monitored is determined as parameter(s) to be monitored, the effective resistance being the sum of the winding resistance of the at least one winding to be monitored and of the winding resistances of the further windings of the transformer transformed toward the at least one winding to be monitored, and the effective inductance, in addition to the self-inductance of the winding to be monitored, also being dependent on a mutual inductance between the at least one winding to be monitored and at least one further winding of the transformer.

**3.** The method according to claim 1, **characterized in that** at least one magnetic coupling coefficient, which describes a magnetic coupling between the at least one winding to be monitored and at least one further winding of the transformer (1), is determined as parameter to be monitored, as a function of a dynamic current-voltage model of the transformer (1), wherein the monitoring is carried out depending on at least one magnetic coupling coefficient.

**4.** The method according to claim 3, **characterized in that**, additionally a self-inductance of the winding to be monitored and/or a winding resistance of the winding to be monitored is/are determined as parameter(s) to be monitored, as a function of the dynamic current-voltage model of the transformer (1), wherein the monitoring is additionally carried out depending on the self-inductance and/or of the winding resistance.

**5.** The method according to any of claims 1 to 4, **characterized in that** an estimated winding voltage of the winding to be monitored is determined as a function of the dynamic current-voltage model of the transformer (1), wherein the parameter(s) to be monitored are determined in such a way that a difference between the estimated winding voltage and the actual winding voltage ($U_1$, $U_2$, $U_3$, $U_4$, $U_5$) is minimal.

**6.** The method according to any of claims 1 to 4, **characterized in that** an estimated winding voltage of a first winding to be monitored and an estimated winding voltage of a further winding to be monitored are determined as a function of the dynamic current-voltage model of the transformer (1), wherein the parameters to be monitored of the first and further windings to be monitored are determined in such a way that a difference between the estimated winding voltages of the first winding to be monitored and of the further winding to be monitored are minimal.

7. The method according to claim 6, **characterized in that** a determination of the parameters to be monitored of the first and further windings to be monitored is carried out as a function of a previously known winding number ratio between the first and further winding to be monitored.

8. The method according to either claim 6 or 7, **characterized in that** the first winding to be monitored is a primary winding (2) of the transformer (1), and the further winding to be monitored is a secondary winding (3, 4, 5, 6) of the transformer.

9. The method according to any of claims 1 to 4, **characterized in that** a difference between an estimated winding voltage of the at least one winding to be monitored and an estimated winding voltage of a further winding of the transformer is determined as a first term, as a function of the dynamic current-voltage model of the transformer (1), wherein a difference between the actual winding voltage of the at least one winding to be monitored and the actual winding voltage of the further winding of the transformer is determined as a second term, wherein the parameter(s) to be monitored are determined in such a way that a difference between the second term and the first term is minimal.

10. The method according to any of claims 1 to 9, **characterized in that** the transformer (1) comprises more than two windings (2, 3, 4, 5, 6), wherein monitoring is carried out for each of the windings (2, 3, 4, 5, 6).

11. The method according to any of claims 1 to 10, **characterized in that** monitoring is carried out as a function of a difference between at least one parameter to be monitored and a corresponding reference parameter, or as a function of a difference between a first parameter to be monitored and at least one further parameter to be monitored, or as a function of a difference between a parameter determined at a first point in time and a corresponding parameter determined at a later point in time.

12. A device for monitoring a state of a transformer (1), the device comprising a means for determining an actual winding current ($I_1$, $I_2$, $I_3$, $I_4$, $I_5$) of at least one winding to be monitored, a means for determining an actual winding current change of the at least one winding to be monitored, and a means for determining an actual winding voltage ($U_1$, $U_2$, $U_3$, $U_4$, $U_5$) of the at least one winding to be monitored, and an evaluation unit (11), wherein a plurality of parameters of the transformer to be monitored is determinable by means of the evaluation unit (11), the actual winding current ($I_1$, $I_2$, $I_3$, $I_4$, $I_5$), the actual winding current change, and the actual winding voltage arising physically in/at the at least one winding to be monitored,
**characterized in that**
the transformer (1) comprises a primary winding (2) and a plurality of secondary windings (3, 4, 5, 6), wherein, as a function of a dynamic current-voltage model of the transformer (1), at least one parameter that is dependent on a winding resistance of the at least one winding to be monitored and at least one parameter that is dependent on a self-inductance and a mutual inductance of the at least one winding to be monitored are determinable as parameters to be monitored by means of the evaluation unit (11), wherein the monitoring is performable depending on the parameters to be monitored.

13. The device according to claim 12, **characterized in that** an effective resistance and/or an effective inductance of the at least one winding to be monitored is determinable as parameter(s) to be monitored by means of the evaluation unit (11), the effective resistance being the sum of the winding resistance of the at least one winding to be monitored and of the winding resistances of the further windings of the transformer transformed toward the at least one winding to be monitored, and the effective inductance, in addition to the self-inductance of the winding to be monitored, also being dependent on a mutual inductance between the at least one winding to be monitored and at least one further winding of the transformer.

14. The device according to claim 12, **characterized in that** at least one magnetic coupling efficient, which describes a magnetic coupling between the at least one winding to be monitored and at least one further winding of the transformer (1), is determinable as parameter to be monitored by means of the evaluation unit (11), as a function of a dynamic current-voltage model of the transformer (1), wherein the monitoring is performable by means of the evaluation unit (11) depending on the at least one magnetic coupling coefficient.

15. The device according to claim 14, **characterized in that** additionally a self-inductance of the winding to be monitored and/or a winding resistance of the winding to be monitored are determinable as parameter(s) to be monitored by means of the evaluation unit (11), by carrying out a minimization of a difference between an estimated winding voltage of the winding to be monitored and the actual winding voltage of the winding to be monitored, or a minimization of a difference between an estimated winding voltage of a first winding to be monitored and an estimated winding voltage of a further winding to be monitored.

**Revendications**

**1.** Procédé de surveillance d'un état d'un transformateur (1), dans lequel sont déterminés un courant d'enroulement réel ($I_1$, $I_2$, $I_3$, $I_4$, $I_5$) d'au moins un enroulement à surveiller, une variation de courant d'enroulement réelle de l'au moins un enroulement à surveiller et une tension d'enroulement réelle ($U_1$, $U_2$, $U_3$, $U_4$, $U_5$) de l'au moins un enroulement à surveiller, dans lequel le courant d'enroulement réel ($I_1$, $I_2$, $I_3$, $I_4$, $I_5$), la variation de courant d'enroulement réelle et la tension d'enroulement réelle se règlent physiquement dans/au niveau de l'au moins un enroulement à surveiller, dans lequel sont déterminés plusieurs paramètres à surveiller du transformateur (1),
**caractérisé en ce que**
le transformateur (1) comprend un enroulement primaire (2) et plusieurs enroulements secondaires (3, 4, 5, 6), dans lequel sont déterminés comme paramètres à surveiller, en fonction d'un modèle courant-tension dynamique du transformateur (1), au moins un paramètre qui est fonction d'une résistance d'enroulement de l'au moins un enroulement à surveiller, et au moins un paramètre qui est fonction d'une inductance propre et d'une inductance mutuelle de l'au moins un enroulement à surveiller, dans lequel la surveillance est effectuée en fonction du paramètre à surveiller.

**2.** Procédé selon la revendication 1, **caractérisé en ce qu'**est/sont déterminée(s) comme paramètre(s) à surveiller une résistance effective et/ou une inductance effective de l'au moins un enroulement à surveiller, dans lequel la résistance effective est la somme de la résistance d'enroulement de l'au moins un enroulement à surveiller et des résistances d'enroulement transformées vers le côté de l'au moins un enroulement à surveiller des autres enroulements du transformateur, dans lequel l'inductance effective, en plus de l'inductance propre de l'enroulement à surveiller, est aussi fonction d'une inductance mutuelle entre l'au moins un enroulement à surveiller et au moins un autre enroulement du transformateur.

**3.** Procédé selon la revendication 1, **caractérisé en ce qu'**est déterminé comme paramètre à surveiller, en fonction d'un modèle courant-tension dynamique du transformateur (1), au moins un coefficient de couplage magnétique qui décrit un couplage magnétique entre l'au moins un enroulement à surveiller et au moins un autre enroulement du transformateur (1), dans lequel la surveillance est effectuée en fonction de l'au moins un coefficient de couplage magnétique.

**4.** Procédé selon la revendication 3, **caractérisé en ce que**, en fonction du modèle courant-tension dynamique du transformateur (1), est/sont déterminées en plus comme paramètre(s) à surveiller une inductance propre de l'enroulement à surveiller et/ou une résistance d'enroulement de l'enroulement à surveiller, dans lequel la surveillance est effectuée en plus en fonction de l'inductance propre et/ou de la résistance d'enroulement.

**5.** Procédé selon l'une des revendications 1 à 4, **caractérisé en ce qu'**une tension d'enroulement estimée de l'enroulement à surveiller est déterminée en fonction du modèle courant-tension dynamique du transformateur (1), dans lequel le(s) paramètre(s) à surveiller est/sont déterminé(s) de telle sorte qu'une différence entre la tension d'enroulement estimée et la tension d'enroulement réelle ($U_1$, $U_2$, $U_3$, $U_4$, $U_5$) soit minimale.

**6.** Procédé selon l'une des revendications 1 à 4, **caractérisé en ce qu'**une tension d'enroulement estimée d'un premier enroulement à surveiller et une tension d'enroulement estimée d'un autre enroulement à surveiller sont déterminées en fonction du modèle courant-tension dynamique du transformateur (1), dans lequel les paramètres à surveiller du premier enroulement et de l'autre enroulement à surveiller sont déterminés de telle sorte qu'une différence entre les tensions d'enroulement estimées du premier enroulement à surveiller et de l'autre enroulement à surveiller soit minimale.

**7.** Procédé selon la revendication 6, **caractérisé en ce qu'**une détermination des paramètres à surveiller du premier enroulement et de l'autre enroulement à surveiller est effectuée en fonction d'un rapport de nombre d'enroulements connu au préalable entre le premier enroulement et l'autre enroulement à surveiller.

**8.** Procédé selon l'une des revendications 6 ou 7, **caractérisé en ce que** le premier enroulement à surveiller est un enroulement primaire (2) du transformateur (1) et l'autre enroulement à surveiller est un enroulement secondaire (3, 4, 5, 6) du transformateur.

**9.** Procédé selon l'une des revendications 1 à 4, **caractérisé en ce que**, en fonction du modèle courant-tension dynamique du transformateur (1), est déterminée comme premier terme une différence entre une tension d'enroulement estimée de l'au moins un enroulement à surveiller et une tension d'enroulement estimée d'un autre enroulement du transformateur, dans lequel est déterminée comme second terme une différence entre la tension d'enroulement réelle de l'au moins un enroulement à surveiller et la tension d'enroulement réelle de l'autre enroulement du transformateur, dans lequel le(s) paramètre(s) à surveiller est/sont déterminé(s) de telle sorte qu'une différence entre le second terme et le premier terme soit minimale.

**10.** Procédé selon l'une des revendications 1 à 9, **caractérisé en ce que** le transformateur (1) comprend plus de deux enroulements (2, 3, 4, 5, 6), dans lequel une surveillance est effectuée pour chacun des enroulements (2, 3, 4, 5, 6).

**11.** Procédé selon l'une des revendications 1 à 10, **caractérisé en ce qu'**une surveillance est effectuée en fonction d'une différence entre au moins un paramètre à surveiller et un paramètre de référence correspondant ou en fonction d'une différence entre un premier paramètre à surveiller et au moins un autre paramètre à surveiller ou en fonction d'une différence entre un paramètre déterminé à un premier moment et un paramètre correspondant déterminé à un moment ultérieur.

**12.** Appareil de surveillance d'un état d'un transformateur (1), dans lequel l'appareil comprend un moyen pour déterminer un courant d'enroulement réel ($I_1$, $I_2$, $I_3$, $I_4$, $I_5$) d'au moins un enroulement à surveiller, un moyen pour déterminer une variation de courant d'enroulement réelle de l'au moins un enroulement à surveiller, un moyen pour déterminer une tension d'enroulement réelle ($U_1$, $U_2$, $U_3$, $U_4$, $U_5$) de l'au moins un enroulement à surveiller, et un dispositif d'évaluation (11), dans lequel peuvent être déterminés au moyen du dispositif d'évaluation (11) plusieurs paramètres à surveiller du transformateur, dans lequel le courant d'enroulement réel ($I_1$, $I_2$, $I_3$, $I_4$, $I_5$), la variation de courant d'enroulement réelle et la tension d'enroulement réelle se règlent physiquement dans/au niveau de l'au moins un enroulement à surveiller,
**caractérisé en ce que**
le transformateur (1) comprend un enroulement primaire (2) et plusieurs enroulements secondaires (3, 4, 5, 6), dans lequel peuvent être déterminés au moyen du dispositif d'évaluation (11) comme paramètres à surveiller, en fonction d'un modèle courant-tension dynamique du transformateur (1), au moins un paramètre qui est fonction d'une résistance d'enroulement de l'au moins un enroulement à surveiller, et au moins un paramètre qui est fonction d'une inductance propre et d'une inductance mutuelle de l'au moins un enroulement à surveiller, dans lequel la surveillance peut être effectuée en fonction des paramètres à surveiller.

**13.** Appareil selon la revendication 12, **caractérisé en ce que** peut/peuvent être déterminée(s) au moyen du dispositif d'évaluation (11) comme paramètre(s) à surveiller une résistance effective et/ou une inductance effective de l'au moins un enroulement à surveiller, dans lequel la résistance effective est la somme de la résistance d'enroulement de l'au moins un enroulement à surveiller et des résistances d'enroulement transformées vers le côté de l'au moins un enroulement à surveiller des autres enroulements du transformateur, dans lequel l'inductance effective, en plus de l'inductance propre de l'enroulement à surveiller, est aussi fonction d'une inductance mutuelle entre l'au moins un enroulement à surveiller et au moins un autre enroulement du transformateur.

**14.** Appareil selon la revendication 12, **caractérisé en ce que** peut être déterminé comme paramètre à surveiller, au moyen du dispositif d'évaluation (11) en fonction d'un modèle courant-tension dynamique du transformateur (1), au moins un coefficient de couplage magnétique qui décrit un couplage magnétique entre l'au moins un enroulement à surveiller et au moins un autre enroulement du transformateur (1), dans lequel, au moyen du dispositif d'évaluation (11), la surveillance peut être effectuée en fonction de l'au moins un coefficient de couplage magnétique.

**15.** Appareil selon la revendication 14, **caractérisé en ce que** peut/peuvent en plus être déterminée (s) au moyen du dispositif d'évaluation (11) comme paramètre(s) à surveiller une inductance propre de l'enroulement à surveiller et/ou une résistance d'enroulement de l'enroulement à surveiller par effectuée une minimisation d'une différence entre une tension d'enroulement estimée de l'enroulement à surveiller et la tension d'enroulement réelle de l'enroulement à surveiller ou une minimisation d'une différence entre une tension d'enroulement estimée d'un premier enroulement à surveiller et une tension d'enroulement estimée d'un autre enroulement à surveiller.

Fig.1

Fig.2

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2474832 A2

**In der Beschreibung aufgeführte Nicht-Patentliteratur**

- **P. BASTARD.** A Transformer Model For Winding Fault Studies. *IEEE Trans. On Power Delivery,* April 1994, vol. 9 (2), 690-698
- Transformer Protection Relay Based on the Induced Voltages. **Y.C. KANG.** International Journal of Electrical Power and Energy Systems. 13. Januar 2007, vol. 29, 281-298

- Multi-secondary transformer: A modeling technique for simulation. **PATEL A.** Fusion Engineering (SOFE), 2011 IEEE/NPSS. IEEE, 26. Juni 2011, 1-5